Europäisches Patentamt

European Patent Office

Office européen des brevets

(19)

(11) **EP 1 358 493 B1**

(12) **EUROPÄISCHE PATENTSCHRIFT**

| | |
|---|---|
| (45) Veröffentlichungstag und Bekanntmachung des Hinweises auf die Patenterteilung:<br>**12.10.2005  Patentblatt 2005/41** | (51) Int Cl.⁷: **G01R 21/06**, G01R 15/14 |
| | (86) Internationale Anmeldenummer:<br>**PCT/IB2002/000298** |
| (21) Anmeldenummer: 02700499.3 | |
| (22) Anmeldetag: **31.01.2002** | (87) Internationale Veröffentlichungsnummer:<br>**WO 2002/063319 (15.08.2002 Gazette 2002/33)** |

(54) **MESSSCHALTUNGSANORDNUNG FÜR ELEKTRIZITÄTSZÄHLER ZUM DIREKTEN ANSCHLUSS**

MEASURING CIRCUIT ARRANGEMENT FOR ELECTRICITY METERS FOR DIRECT CONNECTION

CIRCUIT DE MESURE DESTINE A DES COMPTEURS ELECTRIQUES POUR CONNEXION DIRECTE

| | |
|---|---|
| (84) Benannte Vertragsstaaten:<br>**AT BE CH CY DE DK ES FI FR GB GR IE IT LI LU MC NL PT SE TR** | (72) Erfinder:<br>• **DE VRIES, Jacob**<br>  **CH-6319 Allenwinden (CH)**<br>• **ULRICH, Adrian**<br>  **CH-6390 Engelberg (CH)** |
| (30) Priorität: **07.02.2001  DE 10105782** | |
| | (74) Vertreter: **Lagler, Louis**<br>**Rentsch & Partner**<br>**Postfach 2441**<br>**8022 Zürich (CH)** |
| (43) Veröffentlichungstag der Anmeldung:<br>**05.11.2003  Patentblatt 2003/45** | |
| (73) Patentinhaber: **Landis+Gyr AG**<br>**6300 Zug (CH)** | (56) Entgegenhaltungen:<br>**EP-A- 0 622 635**   **US-A- 5 701 253** |

## Beschreibung

Die Erfindung ist dem Gebiet der Zählertechnik zuzuordnen. Sie betrifft eine Messschaltungsanordnung zur Spannungserfassung und Stromerfassung bei Elektrizitätszählern zum direkten Anschluss.

## STAND DER TECHNIK

In industrieanwendungen haben sich elektronische Elektrizitätszähler bereits wegen ihrer Vorteile gegenüber elektromechanischen Zählem weitgehend durchgesetzt. Der Anschluss dieser Industriezähler erfolgt bekanntermassen indirekt, also Ober Stromwandler bzw. Spannungswandler, die entsprechende, normgerechte Charakteristiken aufweisen. Als herausragende Eigenschaften elektronischer Zähler sind vor allem die Möglichkeit der Fernablesbarkeit zu nennen, die Wartungsfreiheit, die geringeren Geräteabmessungen, die höhere Genauigkeit und der erweiterte Strombereich.

Im Hinblick auf diese gegenüber elektromechanischen Zählem offensichtlichen Vorteilen gewinnt der Einsatz von elektronischen Elektrizitätszählern auch in Haushalten zunehmend an Bedeutung. Ein grundsätzlicher Unterschied zwischen diesen Haushaltszählem und den oben erwähnten industriezählem ist in ihrer installationsanordnung zu sehen. So sind Haushalszähler typischerweise direkt angeschlossen; dies bedeutet, dass sie unmittelbar an der Leitung zur anhängenden Last angeschlossen sind. Dabei fällt der Stromertassung eine Schlüsselrolle zu, da hier die Potentialtrennung zum Zähler erfolgt und zudem hohe Anforderungen gemäss der internationalen Norm IEC 1036 an diese Zähler gestellt werden. Die normgerechten Anforderungen an die Genauigkeit bei der Stromerfassung und der Spannungserfassung umfassen einen kleinen Amplitudenfehler (<1%), einen kleinen Phasenfehler (<0.3°) und einen kleinen Linearitätsfehler. Darüber hinaus muss eine Gleichstromtoleranz von $I_{max}/\pi$ gemäss der genannten Norm erreicht werden; das bedeutet, dass ein solcher elektronischer Elektrizitätszähler bei Mischstrombeaufschlagung mit einem Gleichstromanteil $\leq I_{max}/\pi$ normgerecht weiter messen können muss. Diese elektronischen Elektrizitätszähler zum direkten Anschluss dürfen also nicht durch den Gleichstromanteil von bis zu $I_{max}/\pi$ in Sättigung gebracht werden, sondem müssen selbst bei einer derartigen Gleichstromvormagnetisierung noch in der Lage sein, den Wechselanteil des Laststroms bis zu $I_{max}$ abzubilden.

Bekannt sind Messschaltungsanordnungen bei denen gleichstromtolerante Stromwandler mit einer Gleichstromfestigkeit bis $\leq I_{max}/\pi$ Verwendung finden, jedoch werden diese gleichstromtolerante Stromwandler den Anforderungen an eine maximal zulässige Phasenverschiebung nicht gerecht, da bei ihnen Phasenverschiebungen zwischen Strom- und Spannungsmesswerten von bis zu 5° auftreten können. Dies bedeutet, dass die gleichstromtoleranten Stromwandler, die aufgrund besonderer Materialwahl kostenintensiver sind als herkömmliche Stromwandler, ergänzt werden müsse durch eine geeignete, ebenfalls mit Aufwand verbundene Phasenkompensationsanordnung.

Eine Korrektur der Phasenverschiebung mittels Zeitverzögerung, wie sie beispielsweise in der DE 196 39 410 A1 beschrieben ist, kann hier nur eingeschränkt Abhilfe schaffen. Da Haushaltszähler Massenprodukte sind, haben wirtschaftliche Faktoren bei der Auswahl aller Bauteile eine besondere Bedeutung. Deshalb ist eine in konventionellen Zählem Installierte Korrektur der Phasenverschiebung lediglich in engen Grenzen mittels Zeitverschiebung möglich, und darüber hinaus ist diese Korrektur mittels Zeitverschiebung nicht an die Frequenz gekoppelt, sodass diese Korrektur für sich betrachtet frequenzabhängig und somit begrenzt ist.

Solange aber Gleichströme in Verbindung mit der Energieverrechnung von den Zählem nicht gemessen, sondern allenfalls "verkraftet" werden müssen, wird die Technik der transformatorisch wirkenden Sensoren - insbesondere wegen ihrer einfachen, preiswerten und robusten Ausführung - Bestand haben. Dabei nimmt man zudem bis anhin in Kauf, dass Stromwandler entsprechend ihrer Auslegung in Bezug auf die Stromdichte grösser, schwerer und somit teurer sind im Vergleich zu anderen Sensoren, wie zum Beispiel vergleichsweise zu Spannungswandlern.

Aus der EP-A-0 622 635 ist eine Messschaltungsanordnüng bekannt mit einem Eingang für eine Stromerfassung, wobei vor diesem Eingang zwischen einem Mess-Shunt und dem Eingang ein Spannungswandler zwecks galvanischer Trennung angeordnet ist.

## DARSTELLUNG DER ERFINDUNG

Die vorliegende Erfindung versucht, den aufgezeigten Probleme abzuhelfen. Es ist deshalb Aufgabe der Erfindung eine Messschaltungsanordnung für Elektrizitätszähler der oben genannten Art anzugeben, die auch bei Mischstrombeaufschlagung in der Lage ist, die Normgrenzwerte einer Gleichstrombeaufschlagung unbeschadet zu verkraften und dabei innerhalb der Normvorgaben Wirk- bzw. Blindleistung bei allen betriebsüblichen Netzfrequenzen korrekt zu erfassen. Des weiteren besteht die Aufgabe der Erfindung darin, dass diese Messschaltungsanordnung robust sein soll und zudem im Sinne einer Massenanwendung einfach und preiswert herstellbar sein soll.

Die Aufgabe der Erfindung wird gelöstdurch die Merkmale des Anspruchs 1. Weitere vorteilhafte Ausgestaltungen der Erfindung sind Gegenstand der Unteransprüche.

Der Kern der Erfindung ist darin zu sehen, dass bei Elektrizitätszählern zum direkten Anschluss, im Strompfad ein Mess-Shunt mit nachgeschaltetem Spannungswandler den zu messenden Strom in eine Spannung transformiert, wobei der Spannungswandler zum einen die galvanische Trennung zum nachgeschalteten Mess-Chip bereitstellt und zum anderen in der Lage ist eine Normgrenzen für einen Winkelfehler zwischen Strom und Spannung zu überscheiten. Dabei ist herauszuheben, dass der Spannungswandler in besonderer Weise anzupassen ist, nämlich, dass der ohmsche Widerstand des Spannungswandlers einerseits gross genug ist, so dass der maximale, normentsprechende Gleichstromanteil des zu messenden Stromes ihn nicht in Sättigung bringt und andererseits aber klein genug ist, so dass der maximale, normentsprechende Winkelfehler im Zusammenspiel mit der Wandlerinduktivität nicht überschritten wird.

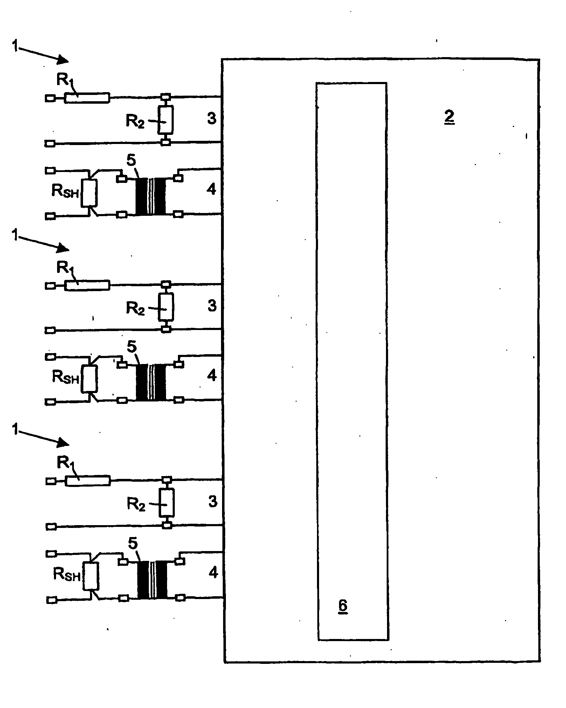

## KURZE BESCHREIBUNG DER ZEICHNUNG

In der Zeichnung ist ein Ausführungsbeispiel schematisch und vereinfacht dargestellt.
Es zeigt die einzige

Fig. eine erfindungsgemässe Messschaltungsanordnung für elektronische Elektrizitätszähler zum direkten Anschluss.

## WEGE ZUR AUSFÜHRUNG DER ERFINDUNG

In der einzigen Fig. ist eine Messschaltungsanordnung 1 für Elektrizitätszähler zum direkten Anschluss dargestellt, die für jede Phase eines Dreiphasennetzes jeweils mit einem Eingang 3 für die Spannungserfassung und einem Eingang 4 für die Stromertassung eines Mess-Chips 2 verbunden ist. Dieser Mess-Chip 2 weist eine Korrektureinrichtung 6 zwecks einer Phasenkompensation zwischen den Spannungswerten und den Stromwerten auf. Vor dem Eingang 3 für die Spannungserfassung ist eine Spannungstellerschaltung, umfassend einen ersten Widerstand $R_1$ und einen zweiten Widerstand $R_2$, angeordnet, die die zu messende Spannung auf einen geeigneten Spannungspegel für den nachgeschalteten Mess-Chip 2 absenkt.

Unmittelbar vor dem Eingang 4 für die Stromerfassung ist ein Spannungswandler 5 installiert, dem wiederum ein Mess-Shunt $R_{SH}$ vorgeschaltet ist Der durch den Mess-Shunt $R_{SH}$ fliessende und zu messende Strom bewirkt an diesem Mess-Shunt $R_{SH}$ einen dem Strombetrag proportionalen Spannungsabfall, der mittels Spannungswandler 5 auf einen geeigneten Spannungspegel für den Eingang 4 der Stromertassung transformiert wird. Mittels einem Windungsverhältnis $N_1/N_2$ zwischen der primärseitigen Windungszahl $N_1$ und der sekundärseitigen Windungszahl $N_2$ lässt sich eine Spannungspegelanpassung für den Eingang 4 zur Stromerfassung am Mess-Chip 2 vomehmen. Darüber hinaus wird mit dem Spannungswandler 5 die nötige galvanische Trennung bereitgestellt.

Im Hinblick auf einen möglichst kleinen Winkelfehler des Spannungswandlers 5, ist primärseitig- also zum Mess-Shunt $R_{SH}$ hin - der Wert des ohmschen Widerstands R (nicht dargestellt) des Spannungswandlers 5 möglichst klein zu wählen. Dies ergibt sich aus der folgenden Überlegung:

Dieser ohmsche Widerstand R verhält sich proportional zum Quadrat der Anzahl primärseitiger Windungen $N_1$ des Spannungswandlers 5:

$$(1) \qquad R = A_R {}^* N_1{}^2,$$

wobei $A_R$ der kemspezifische Primärwicklungswiderstandsbeiwert ist.

Gleiches gilt für die Induktität L (ebenfalls nicht dargestellt) des Spannungswandlers 5, allerdings unter Berücksichtung des kemspezifischen Hauptinduktivitätsbeiwerts $A_L$:

$$(2) \qquad L = A_L {}^* N_1{}^2.$$

Für den Winkelfehler $\delta$ gilt bekanntermassen:

$$(3) \qquad \tan\delta = \frac{R}{\omega L} = \frac{A_R N_1{}^2}{\omega A_L N_1{}^2} = \frac{A_R}{\omega A_L}.$$

Daraus folgt, dass der Winkelfehler $\delta$ - der normentsprechend bei der Energiemessung möglichst klein sein soll - unabhänglg von der Windungszahl des Spannungswandlers 5 ist, womit also lediglich der ohmsche Widerstand R nach (1) im Verhältnis zur Impedanz $\omega L$, mit L nach (2), möglichst klein gewählt werden muss.

Des weiteren gilt aber für den ohmschen Widerstand R des Spannungswandlers 5, dass er mindestens so gross sein muss, dass der durch ihn fliessende Gleichstromanteil der Norm entsprechend den Spannungswandler nicht unzulässig vormagnetisiert. Die Messschaltungsanordnung 1 - umfassend den Spannungswandler 5 vor dem Eingang 4 für die Stromerfassung - muss nämlich normgemäss in der Lage sein, einen Gleichstromanteil $\leq I_{max/\pi}$ des diese Messschaltungsanordnung 1 belastenden Mischstromes zu verkraften und dabei dennoch den Wechselstromanteil für die Energiemessung in dem Elektrizitätszähler zum direkten Anschluss zu erfassen.

Aus diesem Grund ist es von Bedeutung, die Messschaltungsanordnung 1 hinsichtlich der Gieichstromtragfähigkeit einer besonderen Auslegung zu unterziehen, wobei lediglich für diese spezielle Betrachtung die Wechselstrommessfählgkeit der Messschaltungsanordnung 1 unberücksichtigt bleibt

Hinsichtlich der Gleichstromtragfähigkeit lässt sich für den Spannungsabfall am Spannungswandler 5 folgendes festmachen:

$$(4) \qquad R_{SH} \, I_{RSH} = R \, I_R,$$

wobei $I_{RSH}$ der durch $R_{SH}$ fliessende Gleichstromanteil ist und $I_R$ der durch R des Spannungswandlers 5 fliessende Gleichstromanteil ist. Gleichung (4) ist äquivalent zu:

$$(5) \qquad I_R = I_{RSH} \, \frac{R_{SH}}{R},$$

Für das magnetische Feld $H_0$ aufgrund der Gleichstrombeaufschlagung im Spannungswandler 5 gilt:

$$(6) \qquad H_0 = I_R \, \frac{N_1}{l_m},$$

wobei $l_m$ für die mittlere Eisenweglänge des magnetischen Kreises steht; daraus folgt mit (5) folgt:

$$(7) \qquad H_0 = I_{RSH} \, \frac{R_{SH}}{R} \, \frac{N_1}{1_m},$$

was äquivalent ist zu

$$(8) \qquad R = \frac{I_{RSH} R_{SH}}{H_0} \, \frac{N_1}{1_m}.$$

Hieraus geht unmittelbar hervor, dass für eine maximal zulässige Feldstärke $H_0 = H_{0max}$ für das gewählte Kernmaterial und einen maximalen Spannungsabfall $I_{RSH} R_{SH}$ am Mess-Shunt der ohmsche Widerstand R des Spannungswandlers direkt proportional zur Windungszahl $N_1$ ist. Demzufolge muss dieser ohmsche Widerstand R grösser oder gleich einem Mindestwert $R_{mind}$ sein, der sich ergibt aus:

$$(9) \qquad R_{mind} \geq \frac{I_{RSH} R_{SH}}{H_{0max} 1_m} \, N_1.$$

Mittels der ersten Bedingung, die sich für den ohmschen Widerstand R des Spannungsteilers 5 aus den Gleichungen (1) bis (3) ergibt, nämlich R in Abhängigkeit vom Quadrat der Windungszahl N1 möglichst klein zu wählen, und der zweiten Bedingung aus Gleichung (9), für R einen Mindestwert in Abhängigkeit von der Windungszahl N1 zu bestimmen, kann somit ein bevorzugter Widerstandwert für R ermittelt werden. Für diesen bevorzugten Widerstandwert R wird dann zum einen der Spannungswandler 5 bei normgerechter Gleichstrombeaufschlagung eines Elekbizftätszählers nicht in Sättigung gebracht und zum anderen der Winkelfehler bei der Transformation möglichst klein gehalten.

Um eine unter Berücksichtung obiger Gleichungen normgerechte Gleichstromverträglichkeit von bis zu $I_{max/\pi}$ der Messschaltungsanordnung 1 zu gewährleisten, ist das Kemmaterial des Spannungswandlers 5 aus einem hochpermeablen Material, wie beispielsweise Ferrit. Permalloy oder einem nanokristallinem Material hergestellt. Diese hochpermeablen Materialien weisen einen grossen Hauptinduktivitätsbeiwerts $A_L$ auf und gut definierte $H_0$-Werte und eignen sich somit in besonderem Masse für den Einsatz in Elektrizitätszählern, die Ihrer IEC-Norm entsprechend gleichstromtolerant sind.

Der Mess-Chip 2 weist - wie bereits erwähnt - eine Korrektureinrichtung 6 zur Phasenkompensation auf, mittels derer eine Phasenverschiebung zwischen dem Eingang 3 für die Spannungserfassung und dem Eingang 4 für die Stromerfassung vorgenommen werden kann. Da diese Phasenverschiebung aufgrund obiger Auslegung des Spannungswandlers in der erfindungsgemässen Messschaltungsanordnung 1 klein ist, kann in Kauf genommen werden, dass die Phasenkompensation mittels Korrektureinrichtung 6 frequenzabhängig ist. Eine einfache Ausführung der Korrektureinrichtung 6 sieht eine programmierbare Verzögerung vor, die mittels Software realisiert wird. Selbstverständlich ist ebenfalls eine mittels Bauelementen realisierte Phasenkompensation durch die Korrektureinrichtung 6 denkbar, wobei einen derartige Kompensation mittels Bauelementen frequenzabhängig ist. Gemäss geltender Norm darf die Phasenverschiebung zwischen Strom und Spannung einen Winkel von 0.3° nicht überschreiten.

Die in der Fig. gezeigte dreiphasige Anordnung einer Messschaltungsanordnung kann selbstverständlich auch lediglich einphasig ausgeführt sein, ohne dass hierfür eine erfinderische Leistung erbracht werden muss.

**BEZUGSZEICHENLISTE**

| | |
|---|---|
| 1 | Messschaltungsanordnung |
| 2 | Mess-Chip |
| 3 | Eingang für Spannungserfassung |
| 4 | Eingang für Stromerfässung |
| 5 | Spannungswandler |
| 6 | Korrektureinrichtung |
| $R_1$ | Widerstand |
| $R_2$ | Widerstand |
| C | Kondensator |
| $R_{SH}$ | Mess-Shunt |

**Patentansprüche**

1. Messschaltungsanordnung (1) für Elektrizitätszähler zum direkten Anschluss mit einen ersten Eingang (3) für die Spannungserfassung und einem zweiten Eingang (4) für eine Stromerfassung, wobei vor dem zweiten Eingang (4) für die Stromerfassung zwischen einem Mess-Shunt ($R_{SH}$) und diesem Eingang (4) ein Spannungswandler (5) zwecks galvanischer Trennung angeordnet ist, **dadurch gekennzeichnet, dass** der Spannungswandler (5) zum Mess-Shunt ($R_{SH}$) hin einen Mindestwert ($R_{mind}$) eines ohmschen Widerstands (R) aufweist, der einerseits eine normgerechte Gleichstrombeaufschlagung des Spannungswandlers (5) ausreichend begrenzt, wobei für diesen Mindestwert ($R_{mind}$) des ohmschen Widerstands (R) gilt,

$$R_{mind} \geq \frac{I_{RSH}R_{SH}}{H_{0max}I_m}N_1$$

mit $I_{RSH}R_{SH}$= ein Gleichspanntrngsabfall am Spannungswandler (5), $H_{0max}$= ein maximal zulässiges magnetisches Feld aufgrund einer Gleichstrombeaufschlagung im Spannungswandler (5), $1_m$ = eine mittlere Eisenweglänge eines magnetischen Kreises im Spannungswandler (5) und $N_1$ = primärseitige Winclungen, und wobei dieser ohmsche Widerstand andererseits klein genug ist, so dass er zusammen mit der Induktivität (L) des Spannungswandlers (5) lediglich einen normzulässigen Winkelfehler δ aufweist, nämlich

$$\tan \delta = \frac{R}{\omega L} = \frac{A_R N_1^2}{\omega A_1 N_1^2} = \frac{A_R}{\omega A_L}$$

mit $\delta \leq 0.3°$, $A_R$ = kemspezifischer Primärwicklungswiderstandsbeiwert, $A_L$ = kemspezifischer Hauptinduktivitätsbeiwerts und $N_1$ = primärseitige Windungen.

2. Messschaltungsanordnung (1) nach Anspruch 1, **dadurch gekennzeichnet, dass** der Spannungswandler (5) als Ringkornwandler ausgebiltet ist.

3. Messschaltungsanordnung (1) nach Anspruch 1 oder 2, **dadurch gekennzeichnet, dass** der Spannungswandler (5) einen hochpermeablen Kern aus Ferrit, Perrrialloy oder einem nanokristallinem Material umfasst.

4. Messschaltungsanordnung (1) nach einem der Ansprüche 1 bis 4. **dadurch gekennzeichnet, dass** ein Mess-Chip (2) mit dem ersten und zweiten Eingang (3, 4) verbunden ist, wobei dieser Mess-Chip (2) eine programmierbare Korrektureinrichtung (6) für einen Abgleich der Phasenkompensation zwischen der Spannungserfassung und der Stromerfassung aufweist.

5. Messschaltungsanordnung nach Anspruch 4, **dadurch gekennzeichnet, dass** mittels einem Windungsverhältnis des Spannungswandlers (5) eine Pegelanpassung für den zweiten Eingang (4) des Mess-Chips (2) einstellbar ist.

**Claims**

1. A measurement circuit arrangement (1) for electricity meters for the direct connection to a first input (3) for the voltage detection and with a second input (4) for a current detection, wherein a voltage transducer (5) is arranged in front of the second input (4) for the current detection between a measurement shunt ($R_{SH}$) and this input (4), for the purpose of galvanic separation, **characterised in that** the voltage transducer (5) towards the measurement shunt ($R_{SH}$) has a minimum value ($R_{mind}$) of an ohmic resistance (R) which on the one hand adequately limits a standard-conforming application of direct current to the voltage transducer (5), wherein the following applies for this minimum value ($R_{mind}$) of the ohmic resistance (R),

$$R_{mind} \geq \frac{I_{RSH}\,R_{SH}}{H_{0max}I_m}\,N_I$$

with $I_{RSH}R_{SH}$ = direct voltage drop at the voltage transducer (5), $H_{0max}$ = a maximal permissible magnetic field on account of the application of a direct current in the voltage transducer (5), $I_m$ = an average iron path length (effective length) of a magnetic circuit in the voltage transducer (5) and $N_1$ = windings on the primary side, and wherein on the other hand this ohmic resistance is small enough so that it together with the inductance (L) of the voltage transducer (5) only has a standard-permissible angular error δ, specifically.

$$\tan \delta = \frac{R}{\omega L} = \frac{A_R N_I^2}{\omega A_L N_I^2} = \frac{A_R}{\omega A_L},$$

with $\delta \leq 0.3°$, $A_R$ is primary winding resistance coefficient specific to the core, $A_L$ = main inductance coefficient specific to the core and $N_1$ = windings on the primary side.

2. A measurement circuit arrangement (1) according to claim 1, **characterised in that** the voltage transducer (5) is designed as a toroidal-core transducer.

3. A measurement circuit arrangement (1) according to claim 1 or 2, **characterised in that** the voltage transducer (5) comprises a highly permeable core of ferrite, permalloy or of a nano-crystalline material.

4. A measurement circuit arrangement (1) according to one of the claims 1 to 4, **characterised in that** a measurement chip (2) is connected to a first and to a second input (3, 4), wherein this measurement chip (2) comprises programmable correction means (6) for an adjustment/trim of the phase compensation between the voltage detection and the current detection.

5. A measurement circuit arrangement according to claim 4, **characterised in that** a signal level matching for the second input (4) of the measurement chip (2) may be set by way of a winding ratio of the voltage transducer (5).

## Revendications

1. Système de circuit de mesure (1) pour compteur électrique, pour raccordement direct à une première entrée (3) pour l'enregistrement de la tension et à une deuxième entrée (4) pour l'enregistrement du courant,

   dans lequel, avant la deuxième entrée (4) pour l'enregistrement du courant, entre un shunt de mesure ($R_{SH}$) et cette entrée (4), un transformateur de tension (5) est disposé à des fins de division galvanique, **caractérisé en ce que** le transformateur de tension (5) présente en direction du shunt de mesure ($R_{SH}$) une valeur minimale ($R_{mind}$) d'une résistance ohmique (R) qui, d'une part, limite suffisamment une sollicitation conforme aux normes par courant continu du transformateur de tension (S), sachant qu'on a, pour une valeur minimale ($R_{mind}$) de la résistance ohmique (R) :

$$R_{mind} \geq \frac{I_{RSH} R_{SH}}{H_{0max} \, I_m} \, N_I$$

   où on a : $I_{RSH} R_{SH}$ = chute de tension continue sur le transformateur de tension (5), $H_{0max}$ = champ magnétique admissible maximal sur la base d'une sollicitation par courant continu dans le transformateur de tension (5), $I_m$ = longueur moyenne de parcours ferré d'une boucle magnétique dans le transformateur de tension (5) et $N_I$ = spires côté primaire, et dans lequel cette résistance ohmique est d'autre part suffisamment faible pour présenter, avec l'inductance (L) du transformateur de tension (5), simplement une erreur d'angle δ admise par les normes, à savoir

$$\tan \delta = \frac{R}{\omega L} = \frac{A_R N_I^2}{\omega A_L N_I^2} = \frac{A_R}{\omega A_L},$$

où δ ≤ 0,3°, $A_R$ = coefficient de résistance de l'enroulement primaire spécifique au noyau, $A_L$ = coefficient d'inductance principal et $N_I$ = spires côté primaire.

2. Système de circuit de mesure (1) selon la revendication 1, **caractérisé en ce que** le transformateur de tension (5) se présente sous forme d'un transformateur de tension à noyau annulaire.

3. Système de circuit de mesure (1) selon la revendication 1 ou 2, **caractérisé en ce que** le transformateur de tension (5) comprend un noyau fortement perméable en ferrite, permalloy ou matériau nanocristallin.

4. Système de circuit de mesure (1) selon une des revendications 1 à 4, **caractérisé en ce qu'**une puce de mesure (2) est reliée à la première et à la deuxième entrée (3, 4) cette puce de mesure (2) présentant un dispositif de correction programmable (6) pour équilibrer la compensation de phase entre l'enregistrement de tension et l'enregistrement de courant.

5. Système de circuit de mesure (1) selon la revendication 4, **caractérisé en ce qu'**une adaptation de niveau pour la deuxième entrée (4) de la puce de mesure (2) est réglable au moyen d'un rapport d'enroulement du transformateur de tension (5).